# EUROPÄISCHE PATENTSCHRIFT

(11) **EP 0 938 595 B1**
(45) Veröffentlichungstag und Bekanntmachung des Hinweises auf die Patenterteilung: **04.12.2002**
(21) Anmeldenummer: 97942905.7
(22) Anmeldetag: 02.09.1997
(51) Int. Cl.: C23C 14/34, H01J 37/34

(54) **VERFAHREN UND VORRICHTUNG ZUR BESCHICHTUNG VON SUBSTRATEN MITTELS GASFLUSSSPUTTERN**
PROCESS AND DEVICE FOR COATING SUBSTRATES BY GAS FLOW SPUTTERING
PROCEDE ET DISPOSITIF POUR L'ENDUCTION DE SUBSTRATS PAR PULVERISATION D'UN FLUX GAZEUX

(30) Priorität: 03.09.1996 DE 19635669
(43) Veröffentlichungstag der Anmeldung: 01.09.1999
(73) Patentinhaber: FRAUNHOFER-GESELLSCHAFT ZUR FÖRDERUNG DER ANGEWANDTEN FORSCHUNG E.V., 80636 München (DE)
(72) Erfinder: JUNG, Thomas, D-38110 Braunschweig (DE); MEYER, Rolf, D-38100 Braunschweig (DE)
(74) Vertreter: Einsel, Martin, Dipl.-Phys.
(86) Internationale Anmeldenummer: EP9704777
(87) Internationale Veröffentlichungsnummer: WO98010114

(56) Entgegenhaltungen:
- DD-A- 294 511
- DE-A- 4 210 125
- US-A- 3 922 214
- US-A- 4 716 340
- US-A- 5 490 910
- MATSUOKA M ET AL: "OXIDE FILM DEPOSITION BY RADIO FREQUENCY SPUTTERING WITH ELECTRON CYCLOTRON RESONANCE PLASMA STIMULATION" JOURNAL OF VACUUM SCIENCE AND TECHNOLOGY: PART A, Bd. 13, Nr. 5, 1.September 1995, Seiten 2427-2434, XP000550440

## Beschreibung

Die Erfindung betrifft ein Verfahren zur Beschichtung von Substraten mittels Gasflußsputtern mit einer Hohlkathoden-Glimmentladung in einem Inertgasstrom sowie eine Vorrichtung zur Beschichtung von Substraten mittels Gasflußsputtem mit einer als Target dienenden Hohlkathode (Haupthohlkathode) und einer Einströmvorrichtung für den Inertgasstrom.

Derartige Hohlkathoden-Sputterquellen sind beispielsweise aus der DE 42 10 125 C2 bekannt. Das damit angewendete Beschichtungsverfahren wird im Fein- bis Grobvakuumbereich betrieben. Der für die Glimmentladung erforderliche Inertgasstrom durchströmt eine Hohlkathode, wobei dort abgestäubtes Kathodenmaterial auf einem über der Kathodenöffnung angeordneten Substrat abgeschieden wird. Dieses Verfahren, allgemein als Gasflußsputtem benannt, erzeugt eine gleichmäßige Beschichtung auf dem zu beschichtenden Substrat ohne übermäßige Erwärmung desselben.

Die aus der DE 42 10 125 C2 bekannte Vorrichtung zum Gasflußsputtem ist mit einer Hohlkathode, einer Einströmungsvorrichtung für den Inertgasstrom, einer Anode, einer geeigneten Stromversorgung sowie einem gegenüber der Öffnung der Hohlkathode angeordneten Substrat ausgestattet. In der genannten Schrift hat die Hohlkathode einen zweiseitig oder einseitig offenen Querschnitt in Form eines Pyramiden- oder Kegelstumpfes oder ist als lineare Hohlkathode in einer weiten V-Form ausgebildet. Die Einströmungsvorrichtung ist mit einer speziellen Gasdüse ausgestattet, so daß der Gasstrom annähernd parallel zur inneren Targetoberfläche der Hohlkathode verläuft. Damit soll eine deutlich größere Oberfläche des zu beschichtenden Substrats bei Erhaltung der Beschichtungsrate beschichtet werden.

Ferner ist aus der DE 42 35 953 A1 eine derartige Sputterquelle mit einer linearen Hohlkathode bekannt, bei der die Hohlkathode aus planaren, parallel angeordneten, gleich oder annähernd gleich großen Elektroden besteht. Die Stirnseiten zwischen den beiden Elektroden sind parallel zum Inertgasstrom mit elektrisch isolierten Stirnwänden abgeschlossen. Auch mit dieser Vorrichtung soll eine Sputterquelle für großflächige Beschichtungen angegeben werden.

In der DD 294 511 A5 wird noch vorgeschlagen, aus der inertgasdurchströmten Hohlkathodenentladung zunächst Inertgasionen geringer Energie auf das zu beschichtende Substrat zu lenken und so dessen Oberflächenreinigung ohne bzw. mit nur geringen Strukturschäden zu bewirken. Anschließend wird durch Veränderung der Betriebsparameter von den die Hohlkathode darstellenden Targets Material abgestäubt und auf dem Substrat abgelagert.

Nachteilig bei den bekannten Hohlkathoden-Sputterquellen ist, daß für große Schichtdicken keine genügend hohe Beschichtungsrate erreicht werden kann. Die Ursache liegt vor allem in der Begrenzung des möglichen elektrischen Leistungseintrags. Durch eine Vergrößerung der Targettiefe kann zwar der Leistungseintrag erhöht werden, dabei nimmt jedoch die Effektivität des Materialtransports aus der Sputterquelle aufgrund der vorzeitigen seitlichen Ausdiffusion eines mit der Tiefe zunehmenden Teils des abgestäubten Materials aus dem Gasstrom heraus stark ab. Die Effektivität des Materialtransportes läßt sich nur durch eine Vergrößerung des Volumenstroms der Inertgasströmung steigern. Für derartige Anordnungen ist jedoch eine hohe Saugleistung der Pumpen erforderlich und es erfolgt ein entsprechend hoher Inertgasverbrauch.

Aufgabe der Erfindung ist es daher, ein gattungsgemäßes Beschichtungsverfahren bzw. eine gattungsgemäße Beschichtungsquelle anzugeben, die eine Beschichtung auf großflächigen Substraten mit erhöhter Beschichtungsrate ermöglicht.

Gelöst wird diese Aufgabe verfahrensgemäß dadurch, daß zusätzliche Ladungsträger durch wenigstens eine zusätzliche Ladungsträgerquelle von außen in den Entladungsbereich eingebracht oder innerhalb der Hohlkathode erzeugt werden.

Durch die zusätzlich vorhandenen Ladungsträger erhöht sich bei gleicher Entladungsspannung der Entladungsstrom und mit ihm die Leistung. Folglich wird mehr Material von den Kathoden (Targets) abgetragen, ohne daß sich dessen Transportweg zum Substrat verlängert und damit die Verluste zunehmen.

Vorzugsweise werden die zusätzlichen Ladungsträger mit einer weiteren Hohlkathoden-Glimmentladung zugeführt.

Wenn eine gegenüber der Hohlkathoden-Glimmentladung höhere Plasmadichte in der weiteren Glimmentladung erzeugt wird, entsteht eine Zunahme an Ladungsträgern für die Hauptentladung. Eine höhere Plasmadichte kann durch einen geringeren Kathodenabstand erreicht werden.

Mit dem erfindungsgemäßen Verfahren kann die beim Gasflußsputtern umgesetzte Leistung stark erhöht werden und damit erfolgt in fast gleichem Maße ein gesteigerter Materialabtrag von den Kathoden. Folglich wird eine entsprechend höhere Schichtwachstumsrate erreicht.

Vorrichtungsgemäß wird die eingangs genannte Aufgabe dadurch gelöst, daß bei einer gattungsgemäßen Vorrichtung wenigstens eine zusätzliche Ladungsträgerquelle in Richtung des Inertgasstromes vor oder innerhalb der Haupthohlkathode vorgesehen ist.

Die zusätzliche Ladungsträgerquelle erhöht bei gleicher Entladungsspannung den Entladungsstrom. Erfindungsgemäß wird damit eine deutlich höhere Beschichtungsrate erreicht, die mit der eingekoppelten Leistung zunimmt. Da die Leistung durch die prozeßbedingte Maximalspannung begrenzt ist, wird erfindungsgemäß ein geringerer elektrischer Widerstand der Entladung erreicht, so daß die Maximalleistung um mindestens das doppelte höher liegt. Die auf die elektrische Leistung bezogene abgeschiedene Materialmenge ist im Vergleich zu bekannten Anordnungen größer, d. h. die Energieausnutzung ist verbessert worden.

Im Vergleich zu bekannten tiefen Hohlkathoden ist bei gleicher Abscheiderate ein geringerer Inertgasverbrauch und eine reduzierte Pumpenleistung festzustellen. Dies rührt von dem weitgehend vollständigen Materialtransport des abgestäubten Kathodenmaterials von der Quelle zum Substrat her.

Besonders vorteilhaft ist eine Anordnung der Ladungsträgerquellen zwischen Haupthohlkathode und Einströmvorrichtung, so daß der aus der Einströmvorrichtung austretende Inertgasstrom die durch die Ladungsträgerquelle zugeführten Ladungsträger in die Haupthohlkathode mitreißt.

Die zusätzliche Ladungsträgerquelle kann beispielsweise eine Thermoemissionskathode sein. Bevorzugt wird jedoch zur Einbringung der zusätzlichen Ladungsträger eine weitere Glimmentladung in einer Zusatzhohlkathode vorgesehen. Diese weitere Glimmentladung brennt auf der dem Substrat abgewandten Seite der Sputterquelle.

Bevorzugt ist dabei, daß die Zusatzhohlkathoden einen zweiseitig oder einseitig offenen Querschnitt haben, wobei eine Öffnung in den Entladungsraum der Haupthohlkathode gerichtet ist. Damit wird eine optimale Zuführung der zusätzlichen Ladungsträger in den Brennraum der Haupthohlkathode gewährleistet.

Dadurch, daß den Hohlkathodeneffekt bewirkende jeweils einander gegenüberliegende Elektrodenoberflächen der Zusatzhohlkathoden zueinander parallel oder zueinander in V- oder U-Form geneigt angeordnet sind, wird eine möglichst gleichmäßige Verteilung der zustätzlichen Ladungsträger im Brennraum der Haupthohlkathode erreicht.

Bevorzugte geometrische Ausgestaltungen ergeben sich insbesondere aus den Unteransprüchen 10 bis 12.

Der Transport der zusätzlichen Ladungsträger kann beispielsweise erfolgen durch Diffusion durch den Konzentrationsgradienten, im Gasstrom oder auch beeinflußt werden durch die Form der Hohlkathoden. Verschiedene Bauformen können diese Mechanismen unterschiedlich unterstützen.

Dadurch, daß der Elektrodenabstand in der Zusatzhohlkathode um den Faktor 2 bis 10 kleiner ist als der Elektrodenabstand in der Haupthohlkathode, wird eine Erhöhung der Plasmadichte in der weiteren Glimmentladung der Zusatzhohlkathode erreicht. Die in der Gesamtanordnung umgesetzte Leistung kann damit verdoppelt oder weiter gesteigert werden. Der Elektrodenabstand in der Haupthohlkathode sollte 5mm bis 10cm betragen, um einerseits eine breite Beschichtungszone zu erzielen und andererseits den Hohlkathodeneffekt noch ausnutzen zu können. Der Elektrodenabstand in der Zusatzhohlkathode sollte demgemäß etwa zwischen 2 mm bis 5 cm betragen.

Die zwischen Anode und den Hohlkathoden angeschlossene Spannungsquelle sollte Gleichspannung, gepulste Gleichspannung oder nieder- bis hochfrequente Wechselspannung im Bereich von 1 Hz bis 10 GHz mit Spannungen von 200 bis 1500 V liefem.

Bevorzugt liegen dabei die Elektroden der Haupthohlkathode wie auch der Zusatzhohlkathode auf gleichem elektrischen Potential.

Um Verunreinigungen in der Beschichtung zu vermeiden, sollten die Elektroden der Zusatzhohlkathode aus dem gleichen Material wie die Elektroden der Haupthohlkathode bestehen.

Um unerwünschte Randeffekte am Kathodenübergang zu vermeiden, sollten die Elektroden der Haupthohlkathode und der Zusatzhohlkathode stetig ineinander übergehen.

Besonders bevorzugt ist es, wenn dem die abgestäubten Teilchen enthaltenden Inertgasstrom zusätzlich Reaktivgas zugeführt wird, etwa über Düsen. Reaktive Beschichtung hat eine große Bedeutung (beispielsweise eine Beschichtung mit Oxiden oder Nitriden). Gerade mit den erfindungsgemäßen Vorrichtungen und Verfahren ist eine Beschichtung sowohl reaktiv wie auch mit reinen Metallschichten möglich.

Besonders bevorzugt ist es, wenn die Einspeisung des Reaktivgases außerhalb der Hohlkathode in Strömungsrichtung hinter der Hohlkathode erfolgt. Durch diese Gaseinspeisung außerhalb des ursprünglich zugeführten Inertgasstromes wird dafür gesorgt, daß das Reaktivgas nicht ins Gehäuse gelangt und somit keine Targetvergiftung etwa durch Oxidation eintritt.

Natürlich ist es für spezielle Schichtsysteme gleichwohl möglich, auch eine Reaktivgaseinspeisung innerhalb der Hohlkathode vorzunehmen.

Matsuoka und Tohno haben in ihrem Aufsatz "Oxide film by radio frequency sputtering with electron cyclotron resonance plasma stimulation" in: Journal of Vacuum Science & Technology A 13 (1995) Sept./Oct., No. 5, ein Verfahren vorgeschlagen, mit dem die Schichteigenschaften bei einer Plasmabeschichtung dadurch verbessert werden, daß ein ECR-Plasma eingesetzt wird. Gasflußsputtem findet nicht statt, es ist auch keine Hohlkathode vorgesehen.

Nachfolgend werden verschiedene Ausführungsbeispiele der Erfindung anhand der Zeichnungen detailliert beschrieben.
Darin zeigt:
- Fig. 1: eine erfindungsgemäße Vorrichtung nach einem ersten Ausführungsbeispiel in schematisierter Schnittdarstellung und
- Fig. 2 bis 6: verschiedene Ausführungsbeispiele der Anordnung der Hauptund Zusatzhohlkathoden in schematisierten Schnittdarstellungen.

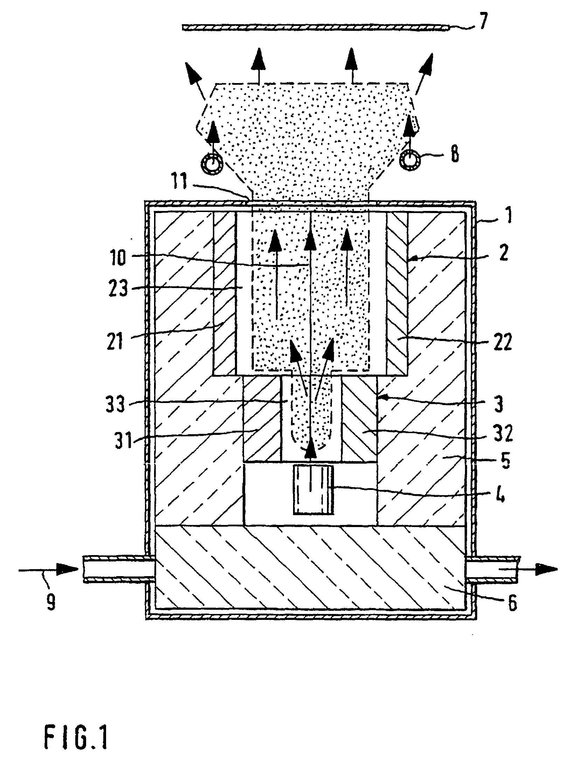

In **Fig. 1** ist ein bevorzugtes Ausführungsbeispiel der Erfindung in schematisierter Schnittdarstellung gezeigt. In einem Gehäuse 1, vorzugsweise aus Metall, sind eine Haupthohlkathode 2 und eine Zusatzhohlkathode 3 aneinander anschließend angeordnet. Zwischen einer nicht dargestellten Anode und den beiden Kathoden ist eine Entladungsspannung mit Hilfe einer nicht dargestellten geeigneten Stromversorgung angelegt. Für den Materialtransport der von den Kathoden abgetragenen Teilchen ist als Einströmvorrichtung ein Düsenstock 4 vorgesehen.

Der Düsenstock 4 ist direkt benachbart zur Zusatzhohlkathode 3, die im dargestellten Ausführungsbeispiel aus zwei ebenen, parallel zueinander angeordneten Elektroden 31 und 32 besteht, angeordnet. Die zweiseitig offene Zusatzhohlkathode 3 geht an ihrer dem Düsenstock 4 abgewandten Öffnung über in die Haupthohlkathode 2, die ebenfalls aus zwei ebenen, parallel angeordneten Elektroden 21 und 22 besteht.

Die Elektroden 21, 22 der Haupthohlkathode 2 weisen einen um den Faktor 2 bis 10 größeren Elektrodenabstand auf als die beiden Elektroden 31, 32 der Zusatzhohlkathode 3. Zwischen den Elektroden 21, 22 der Haupthohlkathode 2 ist ein das sich bildende Plasma enthaltener Hohlraum 23 ausgebildet. Ebenso ist in der Zusatzhohlkathode 3 zwischen den Elektroden 31, 32 ein Hohlraum 33 ausgebildet.

Die Elektroden 21, 22, 31, 32 der Hohlkathoden 2, 3 sind an symmetrisch zur Inertgasströmung angeordneten Targetkühlplatten 5 befestigt. Die Targetkühlplatten 5 stehen wiederum mit einer Basiskühlplatte 6 in thermisch leitender Verbindung. An die Basiskühlplatte 6 ist ein Kühlmittelkreislauf 9 angeschlossen. Dieser ist dadurch zeichnerisch angedeutet, daß ein von links in das Bild zeigender Pfeil den Zufluß von Kühlmittel andeutet, während das in der Basiskühlplatte mit Wärme beaufschlagte Kühlmittel nach rechts in Pfeilrichtung aus dem Bild heraus wieder zur Kühlung zurückgeführt wird.

Das die voranstehend beschriebenen Bauteile umfassende Gehäuse 1 ist zu den angrenzenden Bauteilen beabstandet und damit isoliert angeordnet. Am vom Düsenstock 4 abgewandten Ende der Haupthohlkathode 2 ist im Gehäuse 1 eine Öffnung 11 für den die abgestäubten Teilchen enthaltenden Inertgasstrom 10 vorgesehen. Gegenüber dieser Öffnung 11 ist ein zu beschichtendes Substrat 7 angeordnet.

Für die Zuführung von Reaktivgas sind außerhalb des Gehäuses 1 Düsen 8 vorgesehen. Damit lassen sich zusätzlich reaktive Beschichtungen durchführen, ohne daß eine Vergiftung der Hohlkathoden 2, 3 erfolgt.

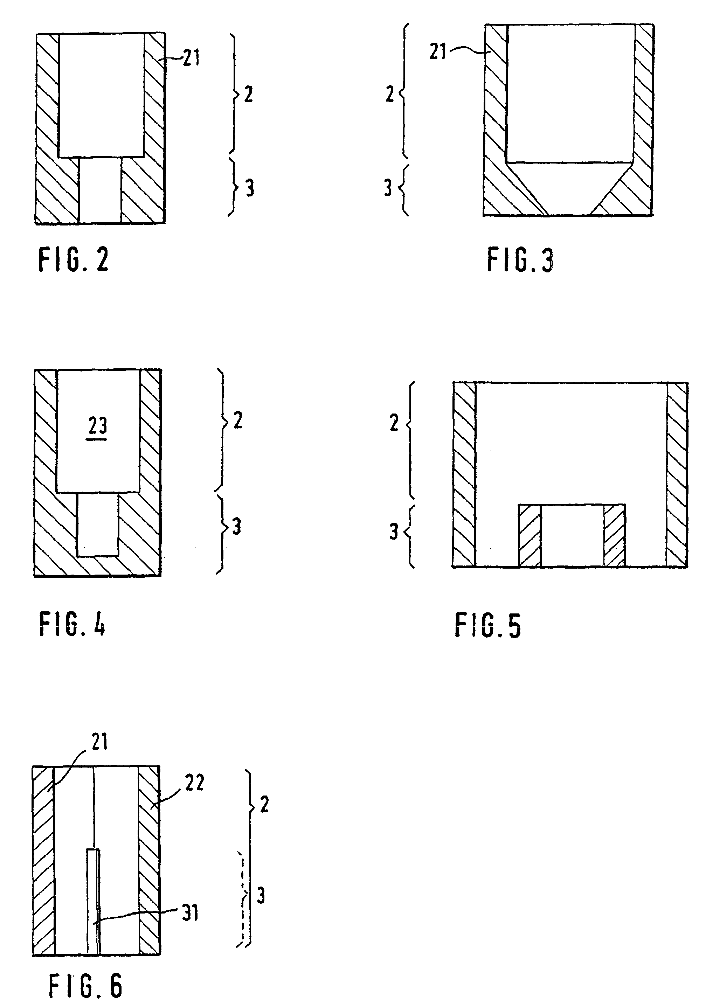

In **Fig. 2** ist eine Elektrodenanordnung ähnlich zu der in Fig. 1 angegeben, bei der jedoch die Haupt- und Zusatz-Hohlkathode 2, 3 zylindrisch ausgebildet ist. Sowohl in dieser als auch den folgenden Figuren kann anstelle dieser rotationssymmetrischen Ausbildung auch eine senkrecht zur Zeichnungsebene gedachte longitudinale Erstreckung der Querschnitte vorgesehen werden.

In **Fig. 3** ist eine wiederum zylindrisch ausgebildete Haupthohlkathode 2 mit Elektrode 21 und einer V-förmigen Zusatzhohlkathode in Gestalt eines Kegelstumpfes dargestellt.

**Fig. 4** zeigt eine Anordnungsalternative, bei der die Zusatzhohlkathode 3 lediglich einseitig offenen Querschnitt hat. Die Öffnung der Zusatzhohlkathode 3 zeigt dabei in den Hohlraum 23 der Haupthohlkathode 2.

In **Fig. 5** ist wiederum eine zylindrische Haupthohlkathode 2 jedoch mit einer davor angeordnete kreisringnutförmige Zusatzhohlkathode 3 dargestellt.

**Fig. 6** zeigt eine zwischen den Elektroden 21, 22 einer Haupthohlkathode 2 angeordneten stabförmigen Elektrode 31 der Zusatzhohlkathode 3. Bei einer rotationssymmetrischen Anordnung würde danach die stabförmige Elektrode 31 umgeben von den halbschaligen Elektroden 21, 22. Bei longitudinal erstreckter Ausbildung könnten auch mehrere stabförmige Elektroden zwischen den dann plattenförmigen Elektroden 21, 22 angeordnet werden.

Nachfolgend wird das erfindungsgemäße Beschichtungsverfahren, teils unter Bezugnahme auf die Zeichnungen, detailliert beschrieben. Für die gewünschte Hohlkathoden-Glimmentladung zwischen der Anode und der zugeordneten Haupthohlkathode 2 wird mit der Einströmvorrichtung 4 ein Inertgas in den Hohlraum 23 der Haupthohlkathode eingeblasen. Erfindungsgemäß werden zwischen der Einströmstelle des Inertgases und der Haupthohlkathode 2 mittels der Zusatzhohlkathode 3 zusätzliche Ladungsträger eingebracht. Damit entsteht im Hohlraum 31 der Zusatzhohlkathode ein gegenüber dem Plasma in der Haupthohlkathode Plasma höherer Dichte. Folglich erhöht sich der Entladungsstrom und somit die Leistung. Im Ergebnis wird mehr Material von den Kathoden abgetragen.

Mit der Inertgasströmung gelangen die von den Kathoden abgestäubten Teilchen durch die Gehäuseöffnung 11 auf das hinter der Öffnung angeordnete Substrat 7. Die Teilchen werden auf dem Substrat abgeschieden und bilden eine Beschichtung. Zur Unterstützung dieses Vorganges kann über zusätzliche Düsen 8 außerhalb des Kathodengehäuses ein Reaktivgas zugeführt werden. Entsprechend der größeren Teilchendichte in dem Plasma wird eine hohe Beschichtungsrate erreicht.

Die Kühlung der durch die Glimmentladung erwärmten Hohlkathoden wird über Targetkühlplatten 5 erreicht. Die Targetkühlplatten werden über die Basiskühlplatte 6 mittels Kühlmittelkreislauf 9 gekühlt. Wenigstens die Elektroden der Haupthohlkathode sind dabei so auf der Targetkühlplatte montiert, daß die Elektroden durch Lösen leicht zugänglicher Schrauben oder Klammem entfernt werden können, ohne daß dabei das Kühlsystem geöffnet werden muß. Die Elektroden sind dabei direkt oder unter Verwendung von gut wärmleitenden Montageplatten auf der Kühlplatte montiert. Damit kann ein Elektroden (Target)-Wechsel bzw. Reinigungsarbeiten sehr einfach und kostengünstig durchgeführt werden. Die Montage der Targets ist dann durch einfaches Herausziehen in Gasflußrichtung nach dem Lösen der Verbindungsschrauben oder -klammem möglich. Das Kühlsystem braucht dabei nicht geöffnet zu werden. Sowohl der Kühlkörper, wie auch seine elektrischen und Kühlmittelanschlüsse sind weder der Plasmaeinwirkung noch parasitären Beschichtungen ausgesetzt. Der Kühlkörper braucht daher bei Wartungsarbeiten nicht demontiert zu werden, so daß Dichtigkeitsprobleme im Kühisystem nicht auftreten.

### Bezugszeichenliste

- 1: Gehäuse
- 2: Hohlkathode (Haupthohlkathode)
- 3: Zusatzhohlkathode, Ladungsträgerquelle
- 4: Einströmvorrichtung
- 5: Targetkühlplatte
- 6: Basiskühlplatte
- 7: Substrat
- 8: Düse
- 9: Kühlmittelkreislauf
- 10: Inertgasstrom
- 11: Öffnung

- 21: Elektrode
- 22: Elektrode
- 23: Hohlraum

- 31: Elektrode
- 32: Elektrode
- 33: Hohlraum

## Patentansprüche

1. Verfahren zur Beschichtung von Substraten mittels Gasflußsputtem mit einer Hohlkathoden-Glimmentladung in einem Inertgasstrom,
**dadurch gekennzeichnet,**
**daß** zusätzliche Ladungsträger durch wenigstens eine zusätzliche Ladungsträgerquelle von außen in den Entladungsbereich eingebracht oder innerhalb der Hohlkathode erzeugt werden.

2. Verfahren nach Anspruch 1,
**dadurch gekennzeichnet,**
**daß** die zusätzlichen Ladungsträger mit einer weiteren Hohlkathoden-Glimmentladung erzeugt und der Hauptkohlkathode zugeführt werden.

3. Verfahren nach Anspruch 2,
**dadurch gekennzeichnet,**
**daß** eine gegenüber der Hohlkathoden-Glimmentladung höhere Plasmadichte in der weiteren Glimmentladung erzeugt wird.

4. Verfahren nach einem der vorstehenden Ansprüche,
**dadurch gekennzeichnet,**
**daß** an die Haupthohlkathode (2) und die Zusatzhohlkathode (3) Gleichspannung, gepulste Gleichspannung oder nieder- bis hochfrequente Wechselspannung im Bereich von 1 Hz bis 10 GHz mit Spannungen von 200 bis 1500 V gelegt wird.

5. Verfahren nach Anspruch 4,
**dadurch gekennzeichnet,**
**daß** die Elektroden der Haupthohlkathode (2) und der Zusatzhohlkathode (3) auf gleiches elektrisches Potential gelegt werden.

6. Verfahren nach einem der vorstehenden Ansprüche,
**dadurch gekennzeichnet,**
**daß** dem die abgestäubten Teilchen enthaltenden Inertgasstrom (10) zusätzlich Reaktivgas zugeführt wird.

7. Vorrichtung zur Beschichtung von Substraten (7) mittels Gasflußsputtem mit einer als Target dienenden Hohlkathode (Haupthohlkathode) (2) und einer Einströmvorrichtung (4) für den Inertgasstrom,
**dadurch gekennzeichnet,**
**daß** wenigstens eine zusätzliche Ladungsträgerquelle (3) in Richtung des Inertgasstromes vor oder innerhalb der Haupthohlkathode (2) vorgesehen ist.

8. Vorrichtung nach Anspruch 7,
**dadurch gekennzeichnet,**
**daß** die Ladungsträgerquellen (3) zwischen Haupthohlkathode (2) und Einströmvorrichtung (4) angeordnet sind.

9. Vorrichtung nach Anspruch 7 oder 8,
**dadurch gekennzeichnet,**
**daß** die zusätzliche Ladungsträgerquelle (3) eine Thermoemissionskathode ist.

10. Vorrichtung nach Anspruch 7 oder 8,
**dadurch gekennzeichnet,**
**daß** die zusätzliche Ladungsträgerquelle (3) eine Zusatzhohlkathode ist.

11. Vorrichtung nach Anspruch 10,
**dadurch gekennzeichnet,**
**daß** die Zusatzhohlkathoden (3) einen zweiseitig oder einseitig offenen Querschnitt haben, wobei eine Öffnung in den Entladungsraum der Haupthohlkathode (2) gerichtet ist.

12. Vorrichtung nach Anspruch 10 oder 11,
**dadurch gekennzeichnet,**
**daß** den Hohlkathodeneffekt bewirkende jeweils einander gegenüberliegende Elektrodenoberflächen (31, 32) der Zusatzhohlkathoden (3) zueinander parallel oder zueinander in V- oder U-Form geneigt angeordnet sind.

13. Vorrichtung nach Anspruch 10, 11 oder 12,
**dadurch gekennzeichnet,**
**daß** die Elektroden (31, 32) der Zusatzhohlkathoden als ebene oder gekrümmte Platten, Zylinder, Scheiben oder Stäbe ausgebildet sind.

14. Vorrichtung nach Anspruch 10, 11 oder 12,
**dadurch gekennzeichnet,**
**daß** die Elektroden (21, 22) der Haupthohlkathode (2) und die Elektroden (31, 32) der Zusatzhohlkathoden (3) eben ausgebildet sind, wobei die Zusatzhohlkathoden (3) im wesentlichen parallel zur Ausdehnung der Haupthohlkathode (2) ausgerichtet sind.

15. Vorrichtung nach Anspruch 10, 11 oder 12,
**dadurch gekennzeichnet,**
**daß** die Elektroden (21, 22) der Haupthohlkathode (2) zylinderförmig ausgebildet sind, wobei die Elektroden (31, 32) der Zusatzhohlkathoden (3) entweder zylinderförmig, stabförmig, kreisringnutförmig oder spiralnutförmig ausgebildet sind.

16. Vorrichtung nach einem der Ansprüche 10 bis 15,
**dadurch gekennzeichnet,**
**daß** der Elektrodenabstand in der Zusatzhohlkathode (3) um den Faktor 2 bis 10 kleiner ist als der Elektrodenabstand in der Haupthohlkathode (2).

17. Vorrichtung nach Anspruch 16,
**dadurch gekennzeichnet,**
**daß** der Elektrodenabstand in der Haupthohlkathode (2) 5 mm bis 10 cm beträgt.

18. Vorrichtung nach einem der Ansprüche 10 bis 17,
**dadurch gekennzeichnet,**
**daß** die Elektroden der Haupthohlkathode (2) und der Zusatzhohlkathode (3) aus gleichem Material bestehen.

19. Vorrichtung nach einem der Ansprüche 10 bis 18,
**dadurch gekennzeichnet,**
**daß** die Elektroden der Haupthohlkathode (2) und der Zusatzhohlkathode (3) stetig ineinander übergehen.

20. Vorrichtung nach einem der Ansprüche 10 bis 19,
**dadurch gekennzeichnet,**
**daß** die Elektroden (21, 22) der Haupthohlkathode (2) und/oder die Elektroden (31, 32) der Zusatzhohlkathode (3) auf gemeinsamen Targetkühlplatten (5) lösbar befestigt sind.

21. Vorrichtung nach einem der Ansprüche 7 bis 20,
**dadurch gekennzeichnet,**
**daß** eine Einspeisung von Reaktivgas außerhalb der Hohlkathode (2) in Strömungsrichtung hinter der Hohlkathode (2) mittels Düsen (8) erfolgt.

## Claims

1. A method of coating substrates by means of a gas flow sputtering process using a hollow-cathode glow-discharge in a stream of inert gas,
**characterised in that**
additional charge carriers are introduced into the discharge region from the exterior by at least one additional charge carrier source or are produced within the hollow cathode.

2. A method in accordance with Claim 1,
**characterised in that**
the additional charge carriers are produced by a further hollow-cathode glow-discharge arrangement and are supplied to the main hollow cathode.

3. A method in accordance with Claim 2,
**characterised in that**
a plasma of higher density compared to that in the hollow-cathode glow-discharge is produced in the further glow discharge.

4. A method in accordance with any of the preceding Claims,
**characterised in that**
a dc voltage, a pulsed dc voltage or a low to high frequency alternating voltage in the range from 1 Hz to 10 GHz having voltages of 200 to 1500 V is applied to the main hollow cathode (2) and the auxiliary hollow cathode (3).

5. A method in accordance with Claim 4,
**characterised in that**
the same electrical potential is applied to the electrodes of the main hollow cathode (2) and of the auxiliary hollow cathode (3).

6. A method in accordance with any of the preceding Claims,
**characterised in that**
a reactive gas is additionally supplied to the stream of inert gas (10) containing the removed particles.

7. A device for coating substrates (7) by means of a gas flow sputtering process including a hollow cathode (main hollow cathode) (2) serving as a target and an intake device (4) for the stream of inert gas,
**characterised in that**
at least one additional charge carrier source (3) is provided prior to the main hollow cathode (2) in the direction of flow of the inert gas or within the main hollow cathode (2).

8. A device in accordance with Claim 7,
**characterised in that**
the charge carrier sources (3) are arranged between the main hollow cathode (2) and the intake device (4).

9. A device in accordance with Claim 7 or 8,
**characterised in that**
the additional charge carrier source (3) is a thermo-emission cathode.

10. A device in accordance with Claim 7 or 8,
**characterised in that**
the additional charge carrier source (3) is an auxiliary hollow cathode.

11. A device in accordance with Claim 10,
**characterised in that**
the auxiliary hollow cathodes (3) have a double-sided or single-sided open cross-section, wherein an opening is directed into the discharge space of the main hollow cathode (2).

12. A device in accordance with Claim 10 or 11,
**characterised in that**
the respective, mutually opposed electrode surfaces (31, 32) of the auxiliary hollow cathodes (3) producing the hollow cathode effect are arranged to be mutually parallel or are mutually inclined to form a V- or U-shape.

13. A device in accordance with Claim 10, 11 or 12,
**characterised in that**
the electrodes (31, 32) of the auxiliary hollow cathodes are in the form of flat or curved plates, cylinders, discs or rods.

14. A device in accordance with Claim 10, 11 or 12,
**characterised in that**
the electrodes (21, 22) of the main hollow cathode (2) and the electrodes (31, 32) of the auxiliary hollow cathodes (3) are flat, wherein the auxiliary hollow cathodes (3) are aligned substantially parallel to the direction of extent of the main hollow cathode (2).

15. A device in accordance with Claim 10, 11 or 12,
**characterised in that**
the electrodes (21, 22) of the main hollow cathode (2) are of cylindrical shape, wherein the electrodes (31, 32) of the auxiliary hollow cathodes (3) are either cylindrical, rod-shaped, annular groove-like or in the form of a spiral groove.

16. A device in accordance with any of the Claims 10 to 15,
**characterised in that**
the spacing between the electrodes in the auxiliary hollow cathode (3) is smaller by a factor of 2 to 10 relative to the spacing between the electrodes in the main hollow cathode (2).

17. A device in accordance with Claim 16,
**characterised in that**
the spacing between the electrodes in the main hollow cathode (2) amounts to 5 mm to 10 cm.

18. A device in accordance with any of the Claims 10 to 17
**characterised in that**
the electrodes of the main hollow cathode (2) and of the auxiliary hollow cathode (3) consist of the same material.

19. A device in accordance with any of the Claims 10 to 18,
**characterised in that**
the electrodes of the main hollow cathode (2) and of the auxiliary hollow cathode (3) merge continuously into one another.

20. A device in accordance with any of the Claims 10 to 19,
**characterised in that**
the electrodes (21, 22) of the main hollow cathode (2) and/or the electrodes (31, 32) of the auxiliary hollow cathode (3) are releasably fixed to common target cooling plates (5).

21. A device in accordance with any of the Claims 7 to 20,
**characterised in that**
a reactive gas is fed-in outside the hollow cathode (2) and behind the hollow cathode (2) in the direction of flow by means of nozzles (8).

## Revendications

1. Procédé de couchage de substrats au moyen de la pulvérisation cathodique par flux gazeux avec une décharge lumineuse à cathode creuse dans un courant de gaz inerte, **caractérisé en ce que** des porteurs de charge complémentaires sont intégrés à travers au moins une source de porteur de charge complémentaire depuis l'extérieur dans la zone de décharge ou générés dans la cathode creuse.

2. Procédé selon la revendication 1, **caractérisé en ce que** les porteurs de charge complémentaires sont générés par une décharge lumineuse à cathode creuse supplémentaire et amenés à la cathode creuse principale.

3. Procédé selon la revendication 2, **caractérisé en ce qu'**une densité de plasma supérieure par rapport à la décharge lumineuse à cathode creuse, est générée dans la décharge lumineuse supplémentaire.

4. Procédé selon l'une quelconque des revendications précédentes, **caractérisé en ce qu'**à la cathode creuse principale (2) et à la cathode creuse complémentaire (3), une tension continue, une tension continue pulsée ou une tension alternative basse à haute fréquence dans la plage de 1 Hz à 10 GHz avec des tensions de 200 à 1500 V est appliquée.

5. Procédé selon la revendication 4, **caractérisé en ce que** les électrodes de la cathode creuse principale (2) et de la cathode creuse complémentaire (3) sont reliées au même potentiel électrique.

6. Procédé selon l'une quelconque des revendications précédentes, **caractérisé en ce qu'**un gaz réactif est amené en plus au courant de gaz inerte (10) contenant les particules pulvérisées.

7. Dispositif de couchage de substrats (7) au moyen de la pulvérisation cathodique par flux gazeux avec une cathode creuse (cathode creuse principale) (2) servant de cible et un dispositif d'admission (4) pour le courant de gaz inerte, **caractérisé en ce qu'**au moins une source de porteur de charge (3) complémentaire est prévue en direction du courant de gaz inerte avant ou à l'intérieur de la cathode creuse principale (2).

8. Dispositif selon la revendication 7, **caractérisé en ce que** les sources de porteur de charge (3) sont agencées entre la cathode creuse principale (2) et le dispositif d'admission (4).

9. Dispositif selon la revendication 7 ou 8, **caractérisé en ce que** la source de porteur de charge complémentaire (3) est une cathode à émission thermique.

10. Dispositif selon la revendication 7 ou 8, **caractérisé en ce que** la source de porteur de charge complémentaire (3) est une cathode creuse complémentaire.

11. Dispositif selon la revendication 10, **caractérisé en ce que** les cathodes creuses complémentaires (3) ont une section transversale ouverte des deux côtés ou d'un côté, un orifice étant orienté dans la chambre de décharge de la cathode creuse principale (2).

12. Dispositif selon la revendication 10 ou 11, **caractérisé en ce que** des surfaces d'électrode (31, 32), provoquant l'effet de cathode creuse et respectivement opposées l'une à l'autre, des cathodes creuses complémentaires (3) sont agencées en parallèle l'une à l'autre ou de façon inclinée en forme de V ou de U l'une par rapport à l'autre.

13. Dispositif selon la revendication 10, 11 ou 12, **caractérisé en ce que** les électrodes (31, 32) des cathodes creuses complémentaires sont réalisées comme des plaques courbes, des cylindres, des disques ou des tiges.

14. Dispositif selon la revendication 10, 11 ou 12, **caractérisé en ce que** les électrodes (21, 22) de la cathode creuse principale (2) et les électrodes (31, 32) des cathodes creuses complémentaires (3) sont réalisées de façon plane, les cathodes creuses complémentaires (3) étant orientées substantiellement en parallèle à la dimension de la cathode creuse principale (2).

15. Dispositif selon la revendication 10, 11 ou 12, **caractérisé en ce que** les électrodes (21, 22) de la cathode creuse principale (2) sont réalisées de façon cylindrique, les électrodes (31, 32) des cathodes creuses complémentaires (3) étant réalisées sous forme de cylindre, sous forme de tige, sous forme de rainure en anneau de cercle ou sous forme de rainure hélicoïdale.

16. Dispositif selon l'une quelconque des revendications 10 à 15, **caractérisé en ce que** l'espace entre les électrodes dans la cathode creuse complémentaire (3) est de 2 à 10 fois inférieur à l'espace entre les électrodes dans la cathode creuse principale (2).

17. Dispositif selon la revendication 16, **caractérisé en ce que** l'espace entre les électrodes dans la cathode creuse principale (2) est de 5 mm à 10 cm.

18. Dispositif selon l'une quelconque des revendications 10 à 17, **caractérisé en ce que** les électrodes de la cathode creuse principale (2) et de la cathode creuse complémentaire (3) se composent du même matériau.

19. Dispositif selon l'une quelconque des revendications 10 à 18, **caractérisé en ce que** les électrodes de la cathode creuse principale (2) et de la cathode creuse complémentaire (3) se confondent sans transition.

20. Dispositif selon l'une quelconque des revendications 10 à 19, **caractérisé en ce que** les électrodes (21, 22) de la cathode creuse principale (2) et/ou les électrodes (31, 32) de la cathode creuse complémentaire (3) sont fixées de façon détachable sur des plaques de refroidissement cible (5) communes.

21. Dispositif selon l'une quelconque des revendications 7 à 20, **caractérisé en ce qu'**une alimentation de gaz réactif est effectuée à l'extérieur de la cathode creuse (2) dans la direction d'écoulement derrière la cathode creuse (2) au moyen de gicleurs (8).
